(19) Europäisches Patentamt
European Patent Office
Office européen des brevets

(11) Publication number: **0 590 486 A2**

(12) **EUROPEAN PATENT APPLICATION**

(21) Application number: **93115238.3**

(22) Date of filing: **22.09.93**

(51) Int. Cl.[5]: **C08F 4/602**, C08F 10/00

(30) Priority: **24.09.92 JP 279371/92**
**08.04.93 JP 106255/93**

(43) Date of publication of application:
**06.04.94 Bulletin 94/14**

(84) Designated Contracting States:
**BE DE ES FR GB IT NL SE**

(71) Applicant: **IDEMITSU KOSAN COMPANY LIMITED**
**1-1, Marunouchi 3-chome**
**Chiyoda-ku**
**Tokyo(JP)**

(72) Inventor: **Yokota, Kiyohiko**
**c/o Idemitsu Kosan Co., Ltd.,**
**1280, Kamiizumi**
**Sodegaura-shi, Chiba-ken(JP)**

(74) Representative: **Hoeger, Stellrecht & Partner**
**Uhlandstrasse 14 c**
**D-70182 Stuttgart (DE)**

(54) **Polymerization catalysts and process for producing polymers.**

(57) A polymerization catalyst comprising the following Compounds (A) and (B), and if desired Compound (C):
(A) a transition metal compound containing a cyclopentadienyl group having at least one heteroatom;
(B) an activating cocatalyst; and
(C) an organoaluminum compound, is disclosed.

These polymerization catalysts are highly active. The use of these catalysts in the production of polyolefins, results in homopolymers or copolymers having high molecular weight and narrow comonomer distribution. Further, the control of the molecular weight and the molecular weight distribution can be made by using these catalysts.

EP 0 590 486 A2

## BACKGROUND OF THE INVENTION

[Field of the Invention]

The present invention relates to a novel, useful polymerization catalyst and a process for producing a polymer using the polymerization catalyst. More particularly, the present invention relates to a polymerization catalyst especially useful as an olefin polymerization catalyst, and a process for producing an olefin based polymer, using the polymerization catalyst.

[Related Art]

Heretofore, as highly active homogeneous olefin polymerization catalysts, those catalysts composed of a transition metal compound and aluminoxane are known (Japanese Patent Application Unexamined Publications Nos. Sho 58-19309 and 60-217209).

Further, it has been proposed that as active species of the homogeneous olefin polymerization catalysts, cation species are useful [J. Am. Chem. Soc. 81, 81 (1959), J. Am. Chem. Soc. 82, 1953 (1960), J. Am. Chem. Soc. 107, 7219 (1985)]. The use of the active species in olefin polymerization after isolation, is described in, for example, J. Am. Chem. Soc. 108, 7410 (1986), Japanese Patent Application PCT publication No. Hei 01-502636, Japanese Patent Application Unexamined Publication No. Hei 03-139504, and European Patent Publication No. 468651. The use of the active species with an organoaluminum compound is described in, for example, Japanese Patent Application Unexamined Publication No. Hei 03-207704 and International Patent Publication No. 92-1723.

However, it is disadvantageous that the resultant polymers prepared by using a complex having a cyclopentadienyl ligand, as described in the above references, will have low molecular weight when polymerized at 70 to 100°C (effective temperature in an industrial process) or more.

The present invention was made in view of the above problems, and has its object of providing a highly active polymerization catalyst which can give rise to resultant homo- or co-polymers having high molecular weight and narrow comonomer distribution, and make it possible to control the molecular weight distribution within narrow range, and a process for producing a polymer using the polymerization catalyst.

## SUMMARY OF THE INVENTION

To achieve the above objects, the present invention provides a polymerization catalyst comprising the following Compounds (A) and (B):

(A) a transition metal compound containing a cyclopentadienyl group having at least one heteroatom; and
(B) an activating cocatalyst such as a compound capable of forming a cation species when reacted with Transitional Metal Compound (A) or its derivative.

Further, the present invention provides a polymerization catalyst comprising the following Compounds (A), (B) and (C):

(A) a transition metal compound containing a cyclopentadienyl group having at least one heteroatom;
(B) an activating co-catalyst; and
(C) an organoaluminum compound.

Further, the present invention provides a process for producing an olefin based (co)polymer, which comprises subjecting olefins to hompolymerization or subjecting an olefin and the other olefins or the other monomers to copolymerization in the presence of the above-mentioned polymerization catalyst.

The other objects and advantages of the present invention will be apparent from the following descriptions.

## DETAILED DESCRIPTION OF PREFERRED EMBODIMENTS OF THE INVENTION

The present invention will be described in more detail below.

1. Transition Metal Compound (A) Having At Least One Heteroatom:

The Transition Metal Compound (A) having at least one heteroatom, which can be used in the present invention, are not particularly limited to, but include a compound represented by the following Formula (I):

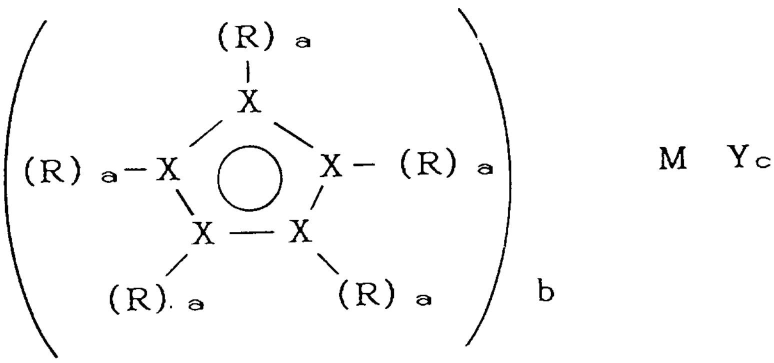

... (I)

wherein M is a metal of Groups 3 to 10 or the Lanthanide Series of the Periodic Table; X is an element belonging to Group 13, 14 or 15 of the Periodic Table; X may be the same as or different from each other; the number of X may be (5 × b), and of these at least one X has an element other than carbon; R is a hydrogen atom, halogen atom, hydrocarbon group having 1 to 20 carbon atoms, oxygen-containing group or arsenic-containing group; R may be the same as or different from each other, and two or more of R together may form a bridge; R and M may form a bridge; a is 0 or 1; b is an integer of at least one, but not greater than the valency of M; group, $[((R)_a)_5X_5]$ may be the same as or different from each other; Y is a σ-bond ligand, chelate ligand or Lewis base; Y may be the same as or different from each other; the group, $[(-(R)_a)_5X_5]$ and Y may form a bridge; and c is an integer of at least 0 and is equivalent to an integer, (the valency of M - b).

In addition, Compound (A) may preferably have, as a heteroatom, at least one atom selected from a phosphorus atom (P), nitrogen atom (N), aluminum atom (Al) and boron atom (B).

Examples of the transition metal compounds include those having one heteroatom such as a phosphorus atom (P), and those having two of heteroatoms such as combination of a nitrogen atom (Al) and a boron atom (B).

More specific examples of the transition metal compounds include those having a metal belonging to Groups 3 to 10 of the Periodic Table such as zirconium, hafnium, titanium and vanadium, or a metal belonging to the Lanthanide Series.

Examples include the following compounds:

Bis(1-phospha-2,3,4,5-tetramethylcyclopentadienyl)zirconium dichloride,
Bis(1-phospha-2,3,4,5-tetramethylcyclopentadienyl)zirconium dibromide,
Bis(1-phospha-2,3,4,5-tetramethylcyclopentadienyl)zirconium dimethyl,
Bis(1-phospha-2,3,4,5-tetramethylcyclopentadienyl)zirconium dibenzyl,
Bis(1-phospha-2,3,4,5-tetramethylcyclopentadienyl)zirconium chloridehydride,
Bis(1-phospha-2,3,4,5-tetramethylcyclopentadienyl)zirconium dihydride,
Bis(1-phospha-2,3,4,5-tetramethylcyclopentadienyl)zirconium bis(dimethylamino)zirconium,
Bis(1-phospha-2,3,4,5-tetramethylcyclopentadienyl)zirconium dimethoxide,
Bis(1-phospha-2,3,4,5-tetramethylcyclopentadienyl)zirconium diphenoxide,
Bis(1-phospha-2,3,4,5-tetramethylcyclopentadienyl)zirconium,
Bis(1-phospha-3,4-diphenylcyclopentadienyl)zirconium dichloride,
Bis(1-phospha-3,4-diphenylcyclopentadienyl)zirconium dimethyl,
Bis(1-phospha-3,4-diphenylcyclopentadienyl)zirconium dibenzyl,
Bis(1-phospha-3,4-diphenylcyclopentadienyl)zirconium chloridehydride,
Bis(1-phospha-3,4-diphenylcyclopentadienyl)zirconium dihydride,
Bis(1-phospha-3,4-diphenylcyclopentadienyl)zirconium dichloride,
Bis(1-phospha-2,5-dimethylcyclopentadienyl)zirconium dichloride,
Bis(1-phospha-2,5-diphenylcyclopentadienyl)zirconium dichloride,
Bis(1-phospha-cycopentadienyl)zirconium dichloride,
Bis(1-phosphaindenyl)zirconium dichloride,
Bis(1-phospha-2,3,4,5-tetramethylcyclopentadienyl)(cyclopentadienyl)zirconium dichloride,
Bis(1-phospha-2,3,4,5-tetramethylcyclopentadienyl)(pentamethylcyclopentadienyl)zirconium dichloride,
(9-Phosphafluorenyl)(cyclopentadienyl)zirconium dichloride,
(1-Phosphaindenyl)(indenyl)zirconium dichloride,
Bis(1-phospha-3-methoxycarbonylcyclopentadienyl)zirconium dichloride,
Ethylenebis(3-phosphaindenyl)zirconium dichloride,

Dimethylsilylene(3-phosphaindenyl)zirconium dichloride,
Dimethylsilylene(3-phospha-4-methylcyclopentadienyl)zirconium dichloride,
Bis(1,3-diphospha-4,5-diphenylcyclopentadienyl)zirconium dichloride,
Bis(1,2,3-triphospha-4,5-diphenylcyclopentadienyl)zirconium dichloride,
Bis(1,2,4-triphospha-3,5-diphenylcyclopentadienyl)zirconium dichloride,
Bis(1,2,3,4-tetraphospha-5-phenylcyclopentadienyl)zirconium dichloride,
Bis(pentaphosphacyclopentadienyl)zirconium dichloride,
Bis(1-phospha-3-benzoyloxycyclopentadienyl)zirconium dichloride,
(1-Phospha-2,3,4,5-tetramethylcyclopentadienyl)zirconium trichloride,
(1-Phospha-2,3,4,5-tetramethylcyclopentadieny)zirconium trimethyl,
(1-Phospha-2,3,4,5-tetramethylcyclopentadienyl)zirconium tribenzyl,
(1-Phospha-2,3,4,5-tetramethylcyclopentadienyl)zirconium methyldichloride,
(1-Phospha-2,3,4,5-tetramethylcyclopentadienyl)zirconium trihydride,
(1-Phospha-3,4-diphenylcyclopentadienyl)zirconium trichloride,
(1-Phospha-3,4-diphenylcyclopentadienyl)zirconium trimethyl,
(1-Phospha-3,4-diphenylcyclopentadienyl)zirconium tribenzyl,
(1-Phospha-3,4-diphenylcyclopentadienyl)zirconium methyldichloride,
(1-Phospha-3,4-diphenylcyclopentadienyl)zirconium trihydride,
(1-Phospha-3,4-dimethylcyclopentadienyl)zirconium trichloride,
(1-Phosphaindenyl)zirconium trichloride,
(1-Phospha-3-methoxycarbonylcyclopentadienyl)zirconium trichloride,
(1,3-Diphospha-4,5-diphenylcyclopentadienyl)zirconium trichloride,
(1,2,4-Triphospha-3,5-diphenylcyclopentadienyl)zirconium trichloride,
(1,2,3,4-Tetraphospha-5-phenylcyclopentadienyl)zirconium trichloride,
(Pentaphosphacyclopentadienyl)zirconium trichloride,
(1-Phospha-3-benzoyloxycyclopentadienyl)zirconium trichloride,
Bis(imidazolylzirconium dichloride,
Bis(pyrroryl)zirconium dichloride,,
Bis(2,5-dimethylpyrrolyl)zirconium dichloride,
Bis(pyrrolyl)zirconium dimethyl,
Bis(pyrrolyl)zirconium dibenzyl,
Bis(pyrrolyl)zirconium chloridehydride,
Bis(pyrrolyl)zirconium dihydride,
Bis(pyrazolyl)zirconium dichloride,
Bis(1,2,3-triazolyl)zirconium dichloride,
Bis(1,2,4-triazolyl)zirconium dichloride,
Bis(tetrazolyl)zirconium dichloride,
Bis(pentazolyl)zirconium dichloride,
(Imidazolyl)zirconium trichloride,
(Imidazolyl)zirconium trimethyl,
(Imidazolyl)zirconium tribenzyl,
(Imidazolyl)zirconium methyldichloride,
(Imidazolyl)zirconium trihydride,
(Pyrazolyl)zirconium trichloride,
(1,2,3-triazolyl)zirconium trichloride,
(1,2,4-triazolyl)zirconium trichloride,
(Tetrazolyl)zirconium trichloride,
(Pentazolyl)zirconium trichloride,
Bis(2,3,4,5-tetramethylarsolyl)zirconium dichloride,
Bis(2,3,4,5,-tetramethylarsolyl)zirconium dimethyl,
(2,3,4,5-tetramethylarsolyl)zirconium trichloride,
Bis(1-sira-pentamethylcyclopentadienyl)zirconium dichloride,
Bis(1-bora-2,3,4,5-tetramethylcyclopentadienyl)zirconium dichloride,
Bis(1-alumina-2,3,4,5-tetramethylcyclopentadienyl)zirconium dichloride,
Bis(1-trimethylsilyl-2-methyl-1H-1,2-azaborolyl)zirconium dichloride,
Bis(1-tert.-butyl-2-methyl-1H-1,2-azaborolyl)zirconium dichloride,
Bis(2-methyl-1H-1,2-azaborolyl)zirconium dichloride,
(Cyclopentadienyl)(1-trimethylsilyl-2-methyl-1H-1,2-azaborolyl)zirconium dichloride,

N,N'-(dimethylsilylene)bis(2-methyl-1H-1,2-azaborolyl)zirconium dichloride,
Dimethylsilylenebis(1-trimethylsilyl-2-methyl-1H-1,2-azaborolyl)zirconium dichloride,
(Cyclopentadiene-1,1-diyl)diemthylsilylene(1-trimethylsilyl-2-methyl-1H-1,2-azaborolyl)zirconium,
Bis(1-phenyl-2-methyl-1-phospha-2-aluminacyclopentadienyl)zirconiumdichloride.

2. Activating Cocatalyst (B):

The Activating Cocatalyst (B) which can be used in the present invention are not particularly limited to, but include a compound (Compound (B')) capable of forming a cation species from Transition Metal Compound (A) or a derivative of Compound (A).

Examples of Compound (B') include a compound (Compound (B-1)) capable of forming an ionic complex when reacted with Transition Metal Compound (A), aluminoxane (Compound (B-2)) and Lewis Base (Compound (B-3)).

Compounds (B-1) capable of forming an ionic complex when reacted with Transition Metal Compound (A), are not particularly limited to, but include any compounds capable of forming an ionic complex when reacted with Transition Metal Compound (A). Preferable compounds useful in the present invention are represented by the following Formula (II) or (III):

$([L^1\text{-}R^1]^{k+})_p([Z]^-)_q$ (II)

$([L^2]^{k+})_p([Z]^-)_q$ (III)

wherein $L^2$ is $M^2$, $R^2R^3M^3$, $R^4{}_3C$ or $R^5M^3$.

In Formula (II) or (III), $[Z]^-$ is a noncoordinating anion $[Z^1]^-$ and $[Z^2]^-$; $[Z^1]^-$ is an anion wherein a plurality of groups are attached to an element, i.e., $[M^1A^1A^2...A^n]^-$ wherein $M^1$ is an element selected from Groups 5 to 15, preferably Groups 13 to 15; $A^1$ to $A^n$ are a hydrogen atom, dialkylamino group, $C_{1-20}$ oxygen-containing group, $C_{1-20}$ hydrocarbon group, organometalloid group, halogen atom or halogenated hydrocarbon group; two or more of $A^1$ to $A^n$ may form a ring; n is an integer, [(valency of center metal $M^1$) + 1]; $[Z^2]^-$ is a Bronsted acid having a pKa value of below -10, a conjugated base of Bronsted acid and Lewis base, or a conjugated base of acids as generally defined as super strong acid; Lewis base may be coordinated; in examples of the anion, $[Z^1]^-$ wherein a plurality of groups are attached to an element, i.e., $[M^1A^1A^2...A^n]^-$, $M^1$ includes B, Al, Si, P, As and Sb, preferably B and Al; and $A^1$ to $A^n$ include dialkylamino groups such as a dimethylamino group and diethylamino group, $C_{1-20}$ oxygen-containing groups such as a methoxy group, ethoxy group, n-butoxy group, phenoxy group and 2,6-di-tert.-butyl-4-methylphenoxy group, $C_{1-20}$ hydrocarbon groups such as a methyl group, ethyl group, n-propyl group, isopropyl group, n-butyl group, isobutyl group, n-octyl group, n-eicosyl group, phenyl group, p-tolyl group, benzyl group, 4-t-butylphenyl group and 3,5-dimethylphenyl group, halogen atoms such as fluorine, chlorine, bromine, iodine, $C_{1-20}$ halogenated hydrocarbon groups such as a p-fluorophenyl group, 3,5-difluorophenyl group, pentachlorophenyl group, 3,4,5-trifluorophenyl group, pentafluorophenyl group and 3,5-di(tirfluoromethyl)phenyl group, and organometalloid groups such as a pentamethylantimony group, trimethylsilyl group, trimethylgelmyl group, diphenylarsine group, dicyclohexylantimony group and diphenylboron group. Examples of noncoordinating anion, i.e., Bronsted acid having a pKa value of below - 10, a conjugated base of Bronsted acid and Lewis base, or a conjugated base of acids as generally defined as super strong acid, $[Z^2]^-$ are trifluoromethanesulfonic acid anion $(CF_3SO_3)^-$, bis(trifluoromethanesulfonyl)methyl anion, bis-(trifluoromethanesulfonyl)benzyl anion, bis(trifluoromethanesulfonyl)amide, perchloric acid anion $(ClO_4)^-$, trifluoroacetic acid anion $(CF_3CO_2)^-$, hexafluoroantimony anion $(SbF_6)^-$, fluorosulfonic acid anion $(FSO_3)^-$, chlorosulfonic acid anion $(ClSO_3)^-$, fluorosulfonic acid anion/5-fluorinated antimony $(FSO_3\text{-}SbF_5)^-$, fluorosulfonic acid anion/5-fluorinated arsenic $(FSO_3\text{-}AsF_5)^-$, and trifluoromethanesulfonic acid anion/5-fluorinated antimony $(CF_3\text{-}SO_3/SbF_5)^-$. $L^1$ is the Lewis base; $R^1$ is a hydrogen atom or $C_{1-20}$ hydrocarbon group; and $R^2$ and $R^3$ are independently a cyclopentadienyl group or substituted cyclopentadienyl group (Cp may be the same as or different from each other); $R^4$ is a $C_{1-20}$ hydrocarbon group or $C_{1-20}$ oxygen-containing group; K is an ion value number of $[L^1\text{-}R^1]$ and $[L^2]$, and is an integer of 1 to 3; p is an integer of at least 1; and q is specified by the formula: $q = (p \times k)$; $M^2$ has an element of Groups 1 to 3, 11 to 13 and 17 of the Periodic Table; $M^3$ is an element of Groups 7 to 12 of the Periodic Table; and $R^5$ is porphyrins, phthalocyanines or aryl group derivatives.

Examples of the Lewis bases are amines such as ammonia, methylamine, aniline, dimethylamine, diethylamine, N-methylaniline, diphenylamine, N,N-dimethylaniline, trimethylamine, triethylamine, tri-n-butylamine, methyldiphenylamine, pyridine, p-bromo-N,N-dimethylaniline and p-nitro-N,N-dimethylaniline;

phosphines such as triethylphosphine, triphenylphosphine and diphenylphosphine; thioethers such as tetrahydrothiophene; ethers such as ethylbenzoate; and nitriles such as acetonitrile and benzonitrile.

Examples of $R^1$ are a hydrogen atom, methyl group, ethyl group, benzyl group and trityl group.

Examples of $R^2$ and $R^3$ are a cyclopentadienyl group, methylcyclopentadienyl group, ethylcyclopentadienyl group and pentamethylcyclopentadienyl group.

Examples of $R^4$ are a phenyl group, p-tolyl group and p-methoxyphenyl group.

Examples of $R^5$ are tetraphenylporphyrin, phthalocyanines, aryl and methacryl.

Examples of $M^2$ are Li, Na, K, Ag, Cu, Br, I and $I_3$.

Examples of $M^3$ are Mn, Fe, Co, Ni and Zn.

Examples of Compound (B-1) capable of forming an ionic complex when reacted with Transition Metal Compound (A) include the following compounds:

Triethylammonium tetraphenylborate, Tri(n-butyl)ammonium tetraphenylborate, Trimethylammonium tetraphenylborate,
Tetraethylammonium tetraphenylborate, Methyltri(n-butyl)ammonium tetraphenylborate, Benzyltri(n-butyl)-ammonium tetraphenylborate, Dimethyldiphenylammonium tetraphenylborate,
Triphenyl(methyl)ammonium tetraphenylborate,
Trimethylanilinium tetraphenylborate,
Methylpyridinium tetraphenylborate,
Benzylpyridinium tetraphenylborate,
Methyl(2-cyanopyridinium) tetraphenylborate,
Triethylammonium tetrakis(pentafluorophenyl)borate,
Tri(n-butyl)ammonium tetrakis(pentafluorophenyl)borate,
Triphenylammonium tetrakis(pentafluorophenyl)borate,
Tetra-n-butylammonium tetrakis(pentafluorophenyl)borate,
Tetraethylammonium tetrakis(pentafluorophenyl)borate,
Benzyl(tri-n-butyl)ammonium tetrakis(pentafluorophenyl)borate,
Methyldiphenylammonium tetrakis(pentafluorophenyl)borate,
Triphenyl(methyl)ammonium tetrakis(pentafluorophenyl)borate,
Methylanilinium tetrakis(pentafluorophenyl)borate,
Dimethylanilinium tetrakis(pentafluorophenyl)borate,
Trimethylanilinium tetrakis(pentafluorophenyl)borate,
Methylpyridinium tetrakis(pentafluorophenyl)borate,
Benzylpyridinium tetrakis(pentafluorophenyl)borate,
Methyl(2-cyanopyridinium) tetrakis(pentafluorophenyl)borate,
Benzyl(2-cyanopyridinium) tetrakis(pentafluorophenyl)borate,
Methyl(4-cyanopyridinium) tetrakis(pentafluorophenyl)borate,
Triphenylphosphonium tetrakis(pentafluorophenyl)borate,
Dimethylanilinium
tetrakis[bis(3,5-ditrifluoromethyl)phenyl]borate,
Ferrocenium tetraphenylborate,
Silver tetraphenylborate, Trityl tetraphenylborate,
Tetraphenylporphyrin manganese tetraphenylborate, Ferrocenium tetrakis(pentafluorophenyl)borate, 1,1'-Dimethylferrocenium tetrakis(pentafluorophenyl)borate,
Decamethylferrocenium tetrakis(pentafluorophenyl)borate,
Silver tetrakis(pentafluorophenyl)borate, Trityl tetrakis(pentafluorophenyl)borate,
Lithium tetrakis(pentafluorophenyl)borate,
Sodium tetrakis(pentafluorophenyl)borate,
Tetraphenylporphyrin manganese tetra(pentafluorophenyl)borate,
Tetrafluorosilver borate,
Hexafluorophosphoric acid silver,
Hexafluoroarsenical silver, Silver perchlorate, Silver trifluoroacetate and Silver trifluoromethanesulphonate.

Chain aluminoxanes, Compound (B-2) may be represented by the following Formula:

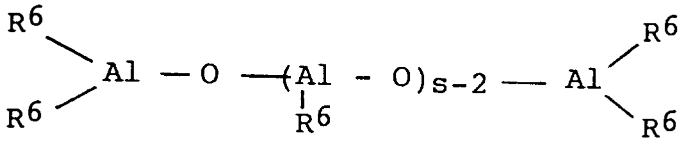 ... (IV)

wherein $R^6$ may be the same as or different from each other, and is a hydrocarbon group such as an alkyl group, alkenyl group, aryl group or arylalkyl group, having 1 to 20, preferably 1 to 12 carbon atoms, or a halogen atom; and s is a degree of polymerization, usually from 3 to 50, preferably 7 to 40.

Cyclic alkylaluminoxanes having a repeating unit represented by the formula:

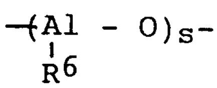 ... (V)

wherein $R^6$ is defined in Formula (IV); and s is a degree of polymerization, usually from 3 to 50, preferably 7 to 40.

Methods of preparing the above aluminoxanes are not particularly limited to, but include any known methods such as a process comprising contacting one or more of alkylaluminum with a condensation agent such as water. Alkylaluminum and a condensation agent can be reacted by known methods, for example, (1) a method comprising dissolving an organoaluminum compound in an organic solvent, and contacting the solution with water; (2) a method comprising adding an organoaluminum compound to starting materials for polymerization, and adding water to the reaction mixture later; (3) a method comprising reacting an organoaluminum compound with crystalline water contained in a metal salt and the like or water adsorbed to an inorganic material or an organic material; and (4) a method comprising reacting tetraalkyldialuminoxane with trialkylaluminum, and then reacting the reaction product with water. In addition, aluminoxanes may be those insoluble to toluene.

Further, Lewis acids, Compound (B-3) are not particularly limited to, but include organic substances and solid inorganic substances. The organic substances include boron compounds and aluminum compounds. The inorganic substances include magnesium compounds and aluminum compounds.

The aluminum compounds include, for example, bis(2,6-di-t-butyl-4-methylpenoxy)aluminum methyl and (1,1'-di-2-naphtoxy)aluminum methyl. The magnesium compounds include, for example, magnesium chloride and magnesium diethoxide. The aluminum compounds include, for example, aluminum oxide and aluminum chloride. The boron compounds include, for example, triphenylborane, tris(pentafluorophenyl)borane, tris[3,5-bis(trifluoromethyl)phenyl]borane, tris[(4-fluoromethyl)phenyl]borane, trimethylborane, triethylborane, tri(n-butyl)borane, tris(fluoromethyl)-borane, tris(pentafluoroethyl)borane, tris(nanofluorobutyl)borane, tris(2,4,6-trifluorophenyl)borane, tris[3,5-bis(trifluoromethyl)phenyl]borane, tris(3,5-difluorophenyl)borane, bis(pentafluorophenyl)fluoroborane, diphenylfluoroborane, bis(pentafluorophenyl)chloroborane, dimethylfluoroborane, diethylfluoroborane, di(n-butyl)fluoroborane, (pentafluorophenyl)difluoroborane, phenyldifluoroborane, (pentafluorophenyl)difluoroborane, phenyldifluoroborane, (pentafluorophenyl)dichloroborane, methyldifluoroborane, ethyldifluoroborane and (n-butyl)-difluoroborane.

In the case of using Compound (B-1), Compound (A) and Compound (B) may be used to provide a Compound (A) to Compound (B) molar ratio of 10:1 to 1:100, preferably 2:1 to 1:10. In the case of using Compound (B-2), Compound (A) and Compound (B) may be used to provide a Compound (A) to Compound (B) molar ratio of 1:1 to 1:100,000, preferably 1:10 to 1:10,000. As Compound (B), Compound (B-1), Compound (B-2) or Compound (B-3) alone may be used, and a combination of two or more of these compounds may also be used. Compound (A) and Compound (B) may be used to provide a Compound (A) to Compound (B-3) molar ratio of 1:0.1 to 1:2,000, preferably 1:0.2 to 1:1,000, more preferably 1:0.5 to 1:500.

3. Organoaluminum Compound (C):

As mentioned above, the polymerization catalysts of the present invention may include, as main ingredients, Organoaluminum Compound (C) in addition to the above-mentioned Compounds (A) and (B). The use of this catalyst in homopolymerization or copolymerization, can improve the polymerization activities.

Organoaluminum Compounds as Compound (C) include those represented by the following Formula (VI):

$R^7{}_rAlQ_{3-r}$ (VI)

wherein $R^7$ is a hydrocarbon group having 1 to 20 carbon atoms, preferably an alkyl group having 1 to 12 carbon atoms; Q is a hydrogen atom, halogen atom, alkoxy group having 1 to 20 carbon atoms or aryl group having 6 to 20 carbon atoms; and r is an integer of 0 to 3.

Examples of compounds represented by Formula (VI) are trimethylaluminum, triethylaluminum, triisopropylaluminum, triisobutylaluminum, dimethylaluminum chloride, diethylaluminum chloride, methylaluminum dichloride, ethylaluminum dichloride, dimethylaluminum fluoride, diisobutylaluminum hydride, diethylaluminum hydride and ethylaluminum sesquichloride.

Of these compounds of Formula (VI), preferable compounds are alkyl group-containing aluminum compounds having at least one alkyl group containing 3 or more carbon atoms, especially a branched alkyl group. Particularly preferred is triisobutylaluminum. The use of triisobutylaluminum or mixtures containing same can result in high activities.

The Compound (A) to Compound (C) molar ratio may range 1:1 to 1:2,000, preferably 1:5 to 1:1,000, more preferably 1:10 to 1:500. The use of Compound (C) may improve polymerization activity. However, the use of excess amount of Compound (C) is not desirable since the organoaluminum compound will be used in vain and a great amount of the organoaluminum compound will remain in the resultant polymer.

4. Carrier [Compound (D)]:

In the polymerization catalyst of the present invention, a carrier may be incorporated as a catalyst component. The carrier [Compound (D)], are not particularly limited to, but include inorganic carriers, inorganic oxide carriers and organic carriers. Of these, inorganic carriers and inorganic oxide carriers are particularly preferable.

More specifically, the inorganic carriers include magnesium compounds or their complex salts such as $MgCl_2$, $MgCl(OEt)$ and $Mg(OEt)_2$, and organic magnesium compounds such as those represented by $MgR^{13}{}_xX^1{}_y$. As used herein, $R^{13}$ is an alkyl group having 1 to 20 carbon atoms, an alkoxy group having 1 to 20 carbon atoms or an aryl group having 6 of 20 carbon atoms; $X^1$ is a halogen atom or an alkyl group having 1 to 20 carbon atoms; x is a number of 0 to 2; and y is a number of 0 to 2.

The inorganic oxide carriers include $SiO_2$, $Al_2O_3$, $MgO$, $ZrO_2$, $TiO_2$, $Fe_2O_3$, $B_2O_3$, $CaO$, $ZnO$, $BaO$, $ThO_2$ and mixtures thereof such as silica alumina, zeolite, ferrite and glass fibers. Of these, $SiO_2$ and $Al_2O_3$ are particularly preferable. In addition the above-mentioned inorganic oxide carriers may contain a small amount of carbonates, nitrates, sulfides or the like.

Further, the organic carriers include, for example, polymers such as polystyrene, styrene-divinylbenzene copolymers, polyethylene, linear low density polyethylene, polypropylene, poly-4-methyl-1-pentene, substituted polystyrene and polyarylate, starches and carbon.

The size of the carrier [Compound (D)], is dependent upon its kind and its production process. The average particle size may usually range from 1 to 300 $\mu$m, preferably from 10 to 200 $\mu$m, more preferably from 20 to 100 $\mu$m.

If the average particle size is small, small particles in the resultant polymers will increase. If the average particle size is large, large particles in the resultant polymers will increase. This results in decrease in bulk density and clogging of a hopper.

Further, the specific surface area of Carrier [Compound (D)] may be usually from 1 to 1,000 $m^2/g$, preferably from 50 to 500 $m^2/g$. The pore volume may be usually from 0.1 to 5 $cm^3/g$, preferably from 0.3 to 3 $cm^3/g$. If the specific surface area or the pore volume is outside of the above ranges, the catalyst activity may be decreased. In addition, the specific surface area and the pore volume can be, for example, measured from volume of nitrogen gas adsorbed in accordance with the BET method (Refer to "J. Am. Chem. Soc., Vol. 60, Page 309 (1983)").

Furthermore, the above-mentioned Carrier [Compound (D)] is preferably used after being calcined at 150 to 1,000°C, preferably at 200 to 800°C.

The olefin polymerization catalysts of the present invention are those comprising the above-mentioned Compound (A) and Compound (B) wherein Compound (A) and/or Compound (B), preferably Compounds (A) and (B) are supported on the above-mentioned Carrier [Compound (D)].

Methods of having Compound (A) and/or Compound (B) supported on the above-mentioned Carrier (D) are not particularly limited to, but include the following methods (1) to (6).

(1) A method of mixing Compound (A) and/or Compound (B) with Carrier (D);

(2) A method of treating Carrier (D) with an organoaluminum compound or a halogen-containing silicon compound, and then mixing Compound (A) and/or Compound (B) with the treated Carrier (D) in an inert solvent;

(3) A method of reacting Carrier (D), Compounds (A) and/or Compound (B) and an organoaluminum compound or a halogen-containing silicon compound;

(4) A method of having Compound (A) or (B) carried on Carrier (D), and then mixing Compound (A) or (B) with the treated Carrier (D);

(5) A method of mixing a contact product of Compound (A) and Compound (B) with Carrier (D); and

(6) A method of reacting Compound (A) with Compound (B) in the presence of Carrier (D).

In addition, in the reaction of the above Method (4), (5) or (6), the above-mentioned Organoaluminum Compound (C) can be added to the reaction system.

The catalysts obtained as above can be used as is for polymerization without any treatment or can be used as a solid after removing the solvent.

Further, in the present invention, the catalyst can be prepared by having Compound (A) and/or Compound (B) supported on Carrier (D) in the polymerization system. In such method, for example, an autoclave is charged with an inert solvent, Compound (A) and/or Compound (B) and, as required, Compound (D) described later. Then, pre-polymerization is carried out at -20°C to 100°C for 1 minute to 2 hours while an olefin such as ethylene is introduced to keep a pressure of from normal pressure to 20 $Kg/cm^2$, to prepare catalysts particles.

In the present invention, a mixing ratio (weight ratio) of Compound (B-1) to Carrier (D) may preferably be from 1:5 to 1:10,000, more preferably from 1:10 to 1:500. In the present invention, a mixing ratio (weight ratio) of Compound (B-2) to Carrier (D) may preferably be from 1:0.5 to 1:1,000, more preferably from 1:1 to 1:50.

Further, a mixing ratio (weight ratio) of Compound (A) to Carrier (D) may preferably be from 1:5 to 1:10,000, more preferably from 1:10 to 1:500. If the mixing ratio of Compound (B) ((B-1) and (B-2)) to Carrier (D) or the mixing ratio of Compound (A) to Carrier (D) is outside of the above ranges, the activity may be decreased.

The olefin polymerization catalysts of the present invention, prepared as above, may have an average particle size of usually from 2 to 200 µm, preferably from 10 to 150 µm, more preferably from 20 to 100 µm; and a specific surface area of usually from 20 to 1,000 $m^2/g$, preferably from 50 to 500 $m^2/g$. If the average particle size is less than 2 µm, small particles in the resultant polymers may increase. If the average particle size is more than 200 µm, large particles in the resultant polymers may increase. If the specific surface area is less than 20 $m^2/g$, the activity may be decreased. If the specific surface area is more than 1000 $m^2/g$, the bulk density of the resultant polymers may be decreased.

Further, in the catalysts of the present invention, the amount of the transition metal contained in 100 g of the carrier may usually be from 0.05 to 10 g, preferably from 0.1 to 2 g. If the amount of the transition metal is outside of the above ranges, the activity may be decreased.

As mentioned above, the use of Carrier (D) may result in the resultant polymers having high bulk density and excellent particle size distribution, which are industrially useful.

6. Production Process of Polymers:

According to the production process of the polymers of the present invention, homopolymerization of an olefin alone, or copolymerization of an olefin and ethylene, the other olefin or the other unsaturated compounds is carried out in the presence of the above-mentioned polymerization catalyst.

In this case, the kind of olefins are not particularly limited. But, alpha-olefins having 2 to 20 carbon atoms are preferable. More specifically, suitable alpha-olefins include, for example, ethylene, propylene, 1-butene, 3-methyl-1-butene, 1-pentene, 1-hexene, 4-methyl-1-pentene, 1-octene, 1-decene, 1-dodecene, 1-tetradecene, 1-hexadecene, 1-octadecene, 1-eicosene, styrene, p-methylstyrene, p-chlorostyrene, p-t-butylstyrene, p-phenylstyrene, p-methylsilylstyrene and p-trimethylsilylstyrene.

In the present invention, when two or more of alpha-olefins are copolymerized, any combination of the above monomers can be used. In the case of copolymerizing ethylene and an alpha-olefin having 3 to 10 carbon atoms, a molar ratio of ethylene to the other alpha-olefins may be usually 99.9:0.1 to 60.0:40.0, preferably 99.5:0.5 to 75.0:25.0.

In the present invention, in addition to the above alpha-olefins, it is possible to polymerize, or copolymerize with the other unsaturated compounds such as chain diolefins such as butadiene, isoprene and 1,5-hexadiene, cyclic olefins such as norbornene and 1,4,5,8-dimethano-1,2,3,4,4a,5,8,8a-octahydronaphthalene, cyclic diolefins such as norbornadiene and ethylidene norbornene, unsaturated esters such as ethylacrylate and methylmethacrylate, and lactones such as beta-propiolactone, beta-butylolactone and gamma-butylolactone.

Polymerization methods are not particularly limited to, but include slurry polymerization, gas phase polymerization, bulk polymerization, solution polymerization and suspension polymerization. Slurry polymerization and gas phase polymerization are particularly preferred.

As for polymerization conditions, the polymerization temperature may range from -100 to 250°C, preferably from -50 to 200°C, more preferably from 0 to 130°C. Further, the catalyst is preferably used in an amount to provide a starting monomer/Component (A) molar ratio or a starting monomer/Component (B) molar ratio of from 1 to $10^8$, preferably from 100 to $10^5$. The polymerization time may usually range from 5 minutes to 10 hours. The reaction pressure may range from normal pressure to 100 $Kg/cm^2G$, preferably from normal pressure to 30 $Kg/cm^2G$.

The molecular weight of the resultant polymer can be controlled by appropriately selecting the amount of each catalyst component and polymerization temperature, or by a polymerization reaction in the presence of hydrogen.

In the case of using polymerization solvents, suitable solvents include aromatic hydrocarbons such as benzene, toluene, xylene and ethylbenzene; alicyclic hydrocarbons such as cyclopentane, cyclohexane and methylcyclohexane; aliphatic hydrocarbons such as pentane, hexane, heptane and octane; and halogenated hydrocarbons such as chloroform and dichloromethane. These solvents can be used alone or in combination. Monomers such as alpha-olefins can also be used as solvent. In addition, the polymerization can be carried out in the absence of a solvent.

In the polymerization process of the present invention, pre-polymerization can be carried out in the presence of the catalyst according to the present invention.

The pre-polymerization can be carried out by any known methods such as a method of bringing a small amount of olefins into contact with the solid catalyst components.

The olefins which can be used in the pre-polymerization are not particularly limited to, but include those olefins mentioned above such as $C_{3-20}$ alpha-olefins or mixtures thereof. It is preferable to use, for the pre-polymerization, the same olefin used in the subsequent polymerization.

Further, the pre-polymerization temperature may usually range from -20 to 100°C, preferably from -10 to 70°C, more preferably from 0 to 50°C.

In the pre-polymerization, inert hydrocarbons, aliphatic hydrocarbons, aromatic hydrocarbons, monomers or the like, can be used as a solvent. Of these, aliphatic hydrocarbons are particularly preferable. In addition, the pre-polymerization can be carried out in the absence of a solvent.

In the pre-polymerization, it is preferable to adjust conditions so that the intrinsic viscosity of the pre-polymer (measured at 135°C in decalin) ranges at least 0.2 dl/g, preferably at least 0.5 dl/g, and that the yield of the pre-polymer ranges from 1 to 10,000 g, preferably from 10 to 1,000 g per 1 millimoles of the transition metal component in the catalyst used.

As mentioned above, the polymerization catalysts according to the present invention show high activities, and the resultant olefin homopolymer or copolymer of olefins produced using the catalysts, will have high molecular weight, and show uniformity in the composition. Also, the molecular weight and the molecular weight distribution can be controlled. Further, the polymers or copolymers having excellent properties can be effectively produced without using a great amount of an organometallc compound.

## EXAMPLES

The present invention will be described in more detail with reference to the following Examples and Comparative Examples, which are not used to limit the present invention.

Example 1

(1) Synthesis of Catalyst Component (A) (Bis(1-phospha-2,3,4,5-tetramethylcyclopentadienyl)zirconium dichloride:

This compound was synthesized with reference to the description of Organometallics 7, p.192 (1988).

(2) Preparation of Catalyst:

(i) A schlenk sufficiently purged with nitrogen was charged with 0.0383 g (0.087 mmol) of bis(1-phospha-2,3,4,5-tetramethylcyclopentadienyl)zirconium dichloride [$(Me_4C_4P)_2ZrCl_2$] under nitrogen atmosphere. Then, 8.7 ml of purified toluene were added to prepare 0.01 M toluene solution containing $(Me_4C_4P)_2ZrCl_2$.

(ii) A schlenk sufficiently purged with nitrogen was charged with 0.0876 g (0.109 mmol) of Catalyst (B) (N,N-dimethylanilinium (tetrakis(pentafluorophenyl)borate ($[PhNMe_2H](B(C_6F_5)_4)$) under nitrogen atmosphere. Then, to this, 10.9 ml of purified toluene were added to prepare 0.01 M toluene solution containing ($[PhNMe_2H](B(C_6F_5)_4$).

(3) Polymerization:

A 1-liter autoclave equipped with an agitating wing, and sufficiently purged with nitrogen, was charged with 400 ml of purified toluene under nitrogen atmosphere. Then, 0.6 ml (0.06 mmol) of a 1.0 M toluene solution containing triisobutylaluminum (TIBA) were added under nitrogen atmosphere. The reaction mixture was kept at 20°C for one hour. Then, 0.3 ml (3.0 μmol) of $(Me_4C_4P)_2ZrCl_2$ prepared in Step (2) above were added under nitrogen atmosphere. Further, 0.3 ml (3.0 μmol) of ($[PhNMe_2H](B(C_6F_5)_4$) prepared in Step (2) above were added under nitrogen atmosphere. The polymerization was carried out for one hour while ethylene was continuously added with agitation so as to keep the pressure at 3 atoms.

As a result, as indicated in Table 1, 9.6 g of polyethylene were obtained. The resultant polymer had, as polyethylene conversion, a weight average molecular weight (Mw) of 574,000, a number average molecular weight (Mn) of 139,000, Mw/Mn of 4.13 and Tm of 136°C.

The measurement conditions for GPC were as follows.

| | |
|---|---|
| Equipment: | ALC/GPS 150C Manufactured by Waters |
| Column: | TSK HM + GMH6X2 Manufactured by Toso |
| Solvent: | 1,2,4-trichlorobenzene |

The measurement conditions for melting point (Tm) were as follows.

| | |
|---|---|
| Equipment: | 7 Series DSC Manufactured by Parkin-Elmar |
| Heat Up Rate: | 10°C/min. |
| Temperature Range: | -50°C to 150°C |
| Intrinsic Viscosity: | Measured in decalin at 135°C |

Examples 2 to 9 and Comparative Example 1

The procedures of Example 1 were repeated except for the conditions as shown in Table 1. The results are as shown in Table 1.

In addition, synthesis of Catalyst Component (A), tetrakis(2,5-dimethylpyrrolyl)zirconium used in Examples 4 and 7 was conducted with reference to the description of Can. J. Chem. 64, p. 1306 (1986).

Table 1

| No. | Cat.Component(A) μmol | Cat.Component(B-1) μmol | Cat.Component(B-2) mmol | Cat.Component(C) mmol | Solvent Toluene ml | Temp. ℃ | Time hr | Monomer |
|---|---|---|---|---|---|---|---|---|
| Ex. 1 | $(Me_4C_4P)_2ZrCl_2$ 3 | $[PhNMe_2H][B(C_6F_5)_4]$ 3 | | TIBA 0.6 | 400 | 20 | 1 | Ethylene 3atm |
| Ex. 2 | $(Me_4C_4P)_2ZrCl_2$ 1 | $[PhNMe_2H][B(C_6F_5)_4]$ 1 | | TIBA 1.0 | 400 | 80 | 1 | Ethylene 8atm |
| Ex. 3 | $(Me_4C_4P)_2ZrCl_2$ 1 | $[PhNMe_2H][B(C_6F_5)_4]$ 1 | | TIBA 1.0 | 360 | 80 | 1/3 | Ethylene 8atm 1-Octene 40ml |
| Ex. 4 | $(2,5\text{-}Me_2C_4H_2N)_4Zr$ 10 | $[PhNMe_2H][B(C_6F_5)_4]$ 10 | | TIBA 1.0 | 400 | 80 | 1 | Ethylene 8atm |
| Ex. 5 | $(Me_4C_4P)_2ZrCl_2$ 1 | | Methylaluminoxane 6 | | 400 | 80 | 1 | Ethylene 8atm |
| Ex. 6 | $(Me_4C_4P)_2ZrCl_2$ 1 | | Methylaluminoxane 6 | | 360 | 80 | 1 | Ethylene 8atm 1-Octene 40ml |
| Ex. 7 | $(2,5\text{-}Me_2C_4H_2N)_4Zr$ 10 | | Methylaluminoxane 6 | | 360 | 80 | 1 | Ethylene 8atm 1-Octene 40ml |
| Ex. 8 | $(Me_4C_4P)_2ZrB_2$ 1 | $[PhNMe_2H][B(C_6F_5)_4]$ 1 | | | 400 | 20 | 1 | Ethylene 3atm |
| Ex. 9 | $(Me_4C_4P)_2ZrCl_2$ 1 | | Methylaluminoxane 6 | | 400 | 50 | 1 | Ethylene 8atm |
| Comp.Ex. 1 | $Cp_2ZrCl_2$ 1 | $[PhNMe_2H][B(C_6F_5)_4]$ 1 | | TIBA 1.0 | 400 | 80 | 25/60 | Ethylene 8atm |

Table 2

| No. | Yield g | **Mw** ($x10^{-4}$) | **Mw/Mn** | [ η] | **Tm** |
|---|---|---|---|---|---|
| Ex. **1** | 9.6 | 57.4 | 4.13 | 7.54 | 136 |
| Ex. **2** | 8.7 | 30.5 | 3.22 | 7.05 | 137 |
| Ex. **3** | 24.6 | 14.7 | 3.42 | 2.78 | 128 |
| Ex. **4** | 0.03 | - | - | - | - |
| Ex. **5** | 12.9 | - | - | 7.61 | 137 |
| Ex. **6** | 29.6 | 24.7 | 3.26 | 3.98 | 126 |
| Ex. **7** | 1.3 | 30.2 | 2.42 | 6.76 | 120 |
| Ex. **8** | 3.2 | - | - | - | - |
| Ex. **9** | 1.0 | 7.91 | 6.18 | 2.28 | 132 |
| Comp. Ex. **1** | 53.6 | 16.4 | 2.78 | 2.69 | 137 |

Example 10

(1) Preparation of Catalyst Component (A) + Catalyst Component (B) (bis(1-phospha-2,3,4,5-tetramethylcyclopentadienyl)zirconium ditriflate:

Bis(1-phospha-2,3,4,5-tetramethylcyclopentadienyl)zirconiumdichloride $[(Me_4C_4P)_2ZrCl_2]$ 0.088 g (0.20 mmol) was dissolved in 10 ml of toluene purged with dry nitrogen to obtain 0.020 M Solution A. Then, silver trifluoromethanesulfonate, 0.103 g (0.40 mmol) was dissolved in 10 ml of toluene purged with dry nitrogen to obtain 0.040 M Solution B. At room temperature, while Solution A was agitated, Solution B was added dropwise to Solution A. The obtained precipitates of silver chloride are filtered off to obtain a 0.010 M solution of bis(1-phospha-2,3,4,5-tetramethylcyclopentadienyl)zirconium ditrifulate, $[(Me_4C_4P)_2Zr][OTf]_2$.

(2) Polymerization:

The procedures of Example 1 were repeated except for the conditions as shown in Table 2. The results are as shown in Table 2.

Example 11 to 13

The procedures of Example 1 were repeated except for the conditions as shown in Table 2. The results are as shown in Table 2.

Example 14

(1) Synthesis of Catalyst Component (A) (Bis(1-phospha-3,4-dimethylcyclopentadienyl)zirconium dichloride):

This compound was synthesized with reference to the description of Synthesis p. 983 (1981) and J. Organomet. Chem. 193, p. C13 (1980).

(2) Polymerization:

The procedures of Example 1 were repeated except for the conditions as shown in Table 2. The results are as shown in Table 2.

Example 15

The procedures of Example 1 were repeated except for the conditions as shown in Table 2. The results are as shown in Table 2.

*[OTf] = Trifluoromethanesulfonate

Table 3

| No. | Cat.Component(A) μmol | Cat.Component(B-1) μmol | Cat.Component(B-2) mmol | Cat.Component(C) mmol | Solvent Toluene ml | Temp. ℃ | Time hr | Monomer |
|---|---|---|---|---|---|---|---|---|
| Ex. 10 | $(Me_4C_4P)_2ZrCl_2$ 100 | AgOTf 100 | | TIBA 1.0 | 400 | 80 | 1 | Ethylene 8atm |
| Ex. 11 | $[(Me_4C_4P)_2Zr][OTf]_2$ 1 | | Methylaluminoxane 6 | TIBA 1.0 | 400 | 80 | 1 | Ethylene 8atm |
| Ex. 12 | $[(Me_4C_4P)_2Zr][OTf]_2$ 1 | $[PhNMe_2H][B(C_6F_5)_4]$ 1 | | TIBA 1.0 | 400 | 80 | 1 | Ethylene 8atm |
| Ex. 13 | $[(Me_4C_4P)_2Zr][OTf]_2$ 1 | $[PhNMe_2H][B(C_6F_5)_4]$ 1 | | TIBA 1.0 | 360 | 80 | 1 | Ethylene 8atm 1-Octene 40ml |
| Ex. 14 | $(Me_2H_2C_4P)_2ZrCl_2$ 1 | $[PhNMe_2H][B(C_6F_5)_4]$ 1 | | TIBA 1.0 | 400 | 80 | 23/60 | Ethylene 8atm |
| Ex. 15 | $(Me_2H_2C_4P)_2ZrCl_2$ 1 | $[PhNMe_2H][B(C_6F_5)_4]$ 1 | | TIBA 1.0 | 360 | 80 | 30/60 | Ethylene 8atm 1-Octene 40ml |

Table 4

| No. | Yield g | **Mw** (x10$^{-4}$) | **Mw/Mn** | [η] | **Tm** |
|---|---|---|---|---|---|
| Ex. 10 | 0.23 | 33.3 | 5.27 | | 133 |
| Ex. 11 | 23.9 | 22.4 | 1.91 | | 137 |
| Ex. 12 | 2.0 | 37.3 | 5.10 | | 134 |
| Ex. 13 | 2.4 | 32.6 | 3.50 | 4.29 | 126 |
| Ex. 14 | 14.7 | 44.6 | 2.15 | 4.45 | 135 |
| Ex. 15 | 8.9 | 16.2 | 1.82 | 2.90 | 123 |

Example 16

(Copolymerization of Ethylene and 2-Norbornene)

Under nitrogen atmosphere, at room temperature, a 1-liter autoclave was charged with, in this order, 40 ml of toluene, 1.2 mmol of triisobutylaluminum (TIBA), 4 μmol of bis(1-phospha-3,4-dimethylcyclopentadienyl)zirconium dichloride and 8 μmol of anilinium tetrakis(pentafluorophenyl) borate. Then, to this, 75 ml of a toluene solution containing 70 weight percent of 2-norbornene (0.4 mol of 2-norbornene) were added. After the mixture was heated to 120°C, the reaction was carried out for 30 minutes while ethylene was continuously supplied so as to keep the ethylene pressure at 6 Kg/cm$^2$.

After the completion of the reaction, the resultant polymer solution was introduced into 1 liter of methanol to precipitate the polymer. The polymer obtained was recovered by filtration, and dried to obtain a cyclic olefin based copolymer.

The yield of the cyclic olefin based copolymer was 2.68 g. The polymerization activity was 7 Kg/g•Zr.

The physical properties of the cyclic olefin based copolymer obtained are as follows.

The norbornene content was 7.5 mol%. The norbornene content was calculated from a ratio of the sum of the peak based on ethylene and the peak based on the methylene group attached to 5th and 6th positions of norbornene, appearing at around 30 ppm in a $^{13}$C-NMR chart, to the peak based on methylene group attached to 7th position of norbornene, appearing at around 32.5 ppm.

The intrinsic viscosity [η] was 1.08 dl/g, and the degree of crystallization, measured by X-ray diffractiometry, was 2.6 %.

The glass transition temperature (Tg) was 0°C. The Tg was calculated from the peak of the loss elasity measured by subjecting a specimen having a width of 45 mm, a length of 40 mm and a thickness of 0.1 mm to RHEO-VIBRON (DDV-II Type: Manufactured by ORIENTECH CO.) at a heat up rate of 3°C/min. with using a frequency of 3.5 Hz.

The weight average molecular weight (Mw), number average molecular weight (Mn) and molecular weight distribution (Mw/Mn) measured, were 45,300, 19,600 and 2.3, respectively. Tm was 85°C (broad peak).

Example 17

(Copolymerization of Ethylene and 1,5-Hexadiene)

The procedures of Example 1(3) were repeated except that 0.1 ml of 1,5-hexadiene were added after addition of toluene, to prepare an ethylene copolymer. As a result, 6.8 g of a polymer were obtained. The polymer had a melting point of 135°C, a weight average molecular weight (Mw), as polyethylene conversion, of 726,000 and a molecular weight distribution of (Mw/Mn) of 6.5.

Example 18

(1) Catalyst Component (A):

In a 200 ml flask purged with nitrogen, 2.0 g of magnesium chloride (average particle size: 70 μm, specific surface area: 260m$^2$/g, pore volume: 260 cc/g) which had been calcined at 300°C for 4 hours, was dispersed in 53.2 ml of toluene. Then, 6.8 ml of a toluene solution containing bis-(tetramethylphosphacyclopentadienyl)zirconium dichloride (0.02 mol/l) were added. After the reaction was

carried out, with agitation, at room temperature for 24 hours, toluene was removed by filtration. The reaction mixture was washed with toluene and dried under reduced pressure to obtain 1.91 g of a solid catalyst. The element analysis showed that the carrying amount per 1 g of the carrier, as zirconium, was 2.8 mg.

(2) Polymerization:

A 1-liter autoclave equipped with an agitating wing and sufficiently purged with nitrogen, was charged with, under nitrogen atmosphere, 400 ml of toluene purged with dried nitrogen, 6.0 mmol of methylaluminoxane and 4.6 μmol (as zirconium conversion) of the catalyst obtained as above. Then, the polymerization was carried out at 80°C for 1 hour while ethylene was continuously supplied to the autoclave at 8 $Kg/cm^2$. As a result, 46.0 g of a polymer in the form of particles were obtained.

The reduced viscosity measured at 135°C in decalin, with concentration of 0.2 g/dl, was 4.9 dl/g.

Example 19

A 1-liter autoclave equipped with an agitating wing, and sufficiently purged with nitrogen, was charged with, under nitrogen atmosphere, 360 ml of toluene purged with dry nitrogen. To this, 40 ml of 1-octene purged with dry nitrogen and 1.0 ml (1.0 mmol) of a 1.0 M toluene solution containing triisobutylaluminum were added under nitrogen atmosphere. The reaction mixture was heated to 60°C. Then, 0.2 ml (2.0 μmol) of a 0.010 M toluene solution containing bis(3,4-dimethyl-1-phosphacyclopentadienyl)zirconium dichloride were added, and then under nitrogen atmosphere, 0.20 ml (2.0 μmol) of a 0.010 M toluene solution containing N,N-dimethylanilinium tetrakis(pentafluorophenyl)borate were added. To this solution, 1.0 ml (10 μmol) of a 0.010 M toluene solution containing tris(pentafluorophenyl)borane were added. After the reaction mixture was heated to 80°C, the polymerization was conducted for one hour while ethylene was continuously added with agitation so as to keep the pressure at 8 atoms.

As a result, 3.8 g of polyethylene were obtained.

The intrinsic viscosity measured at 135°C in decalin, with concentration of 0.2 g/dl, was 5.2 dl/g.

Example 20

A 1-liter autoclave equipped with an agitating wing, and sufficiently purged with nitrogen, was charged with 520 ml of toluene purged with dry nitrogen. Then, to this, 180 ml of 1-octene purged with dry nitrogen and 1.50 ml (1.50 mmol) of a 1.0 M toluene solution containing triisobutylaluminum were added under nitrogen atmosphere. The reaction mixture was heated to 150°C and the ethylene pressure was kept at 24 atoms. Into a catalyst supplying tube sufficiently purged with nitrogen and connected to the autoclave, 20 ml of toluene purged with dry nitrogen was introduced under nitrogen atmosphere. Further, 1.0 ml (10 μmol) of a 0.010 M toluene solution containing bis(3,4-dimethyl-1-phosphacyclopentadienyl)zirconium dichloride were added, and under nitrogen atmosphere, 1.2 ml (12 μmol) of a 0.010 M toluene solution containing N,N-dimethylanilinium tetrakis(pentafluorophenyl)borate were added. The catalyst was introduced by ethylene pressure to the 1-liter autoclave while the content of the autoclave was agitated. Then, the polymerization was carried out for 1 hour while ethylene was continuously added so as to keep the autoclave inner pressure at 24 atoms.

As a result polyethylene were obtained.

## Claims

**1.** A polymerization catalyst comprising the following Compounds (A) and (B):
(A) a transition metal compound containing a cyclopentadienyl group having at least one heteroatom; and
(B) an activating cocatalyst.

**2.** A polymerization catalyst comprising the following Compounds (A), (B) and (C):
(A) a transition metal compound containing a cyclopentadienyl group having at least one heteroatom;
(B) an activating cocatalyst; and
(C) an organoaluminum compound.

**3.** A polymerization catalyst according to Claim 1 or 2, wherein Compound (B) is a compound (Compound (B')) capable of forming a cation species from Transition Metal Compound (A) or its derivative.

4. A polymerization catalyst according to Claim 1 or 2, wherein Compound (A) is a compound represented by the following Formula (I):

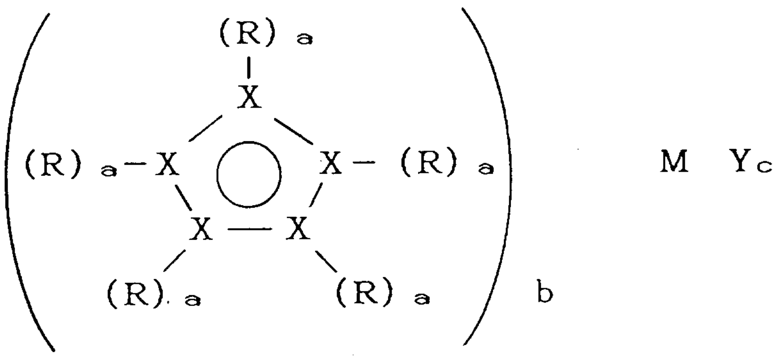

(I)

wherein M is a metal of Groups 3 to 10 or the Lanthanide Series of the Periodic Table; X is an element belonging to Group 13, 14 or 15 of the Periodic Table; X may be the same as or different from each other; the number of X may be (5 × b), and of these at least one X has an element other than carbon; R is a hydrogen atom, halogen atom, hydrocarbon group having 1 to 20 carbon atoms, oxygen-containing group or arsenic-containing group; R may be the same as or different from each other, and two or more of R together may form a bridge; R and M may form a bridge; a is 0 or 1; b is an integer of at least one, but not greater than the valency of M; group, $[((R)_a)_5X_5]$ may be the same as or different from each other; Y is a σ-bond ligand, chelate ligand or Lewis base; Y may be the same as or different from each other; the group, $[((R)_a)_5X_5]$ and Y may form a bridge; and c is an integer of at least 0 and is equivalent to an integer, (the valency of M - b).

5. A polymerization catalyst according to Claim 1 or 2, wherein Compound (A) is a transition metal compound having, as a heteroatom, at least one atom selected from a phosphorus atom (P), nitrogen atom (N), aluminum atom (Al) and boron atom (B).

6. A polymerization catalyst according to Claim 1 or 2, wherein Compound (A) is a transition metal compound containing a metal of Group 4 of the Periodic Table.

7. A polymerization catalyst according to Claim 3, wherein Compound (B') is a compound (Compound (B-1)) capable of forming an ionic complex when reacted with Transition Metal Compound (A) or its derivative.

8. A polymerization catalyst according to Claim 3, wherein Compound (B') is aluminoxane (Compound (B-2)).

9. A polymerization catalyst according to Claim 3, wherein Compound (B') is Lewis acid (Compound (B-3)-).

10. A polymerization catalyst according to Claim 3, wherein Compound (B') is composed of at least two compounds selected from the group consisting of Compound (B-1), Compound (B-2) and Compound (B-3).

11. A polymerization catalyst according to Claim 2, wherein at least one of Compound (A), Compound (B) and Compound (C) are supported on a carrier (Compound (D)).

12. A process for producing a polymer, which comprises subjecting a monomer to homopolymerization or copolymerization in the presence of the polymerization catalyst according to any one of Claims 1 to 11.

13. A process for producing a polymer, which comprises subjecting an olefin to hompolymerization or subjecting an olefin and the other olefins or the other monomers to copolymerization in the presence of the polymerization catalyst according to any one of Claims 1 to 11.